# EUROPEAN PATENT APPLICATION

(11) **EP 4 513 568 A1**
(43) Date of publication of application: **26.02.2025**
(21) Application number: 23192390.5
(22) Date of filing: 21.08.2023
(51) Int. Cl.: H01L 29/40, H01L 29/41, H01L 29/78, H01L 29/739, H01L 21/336

(54) **POWER SEMICONDUCTOR DEVICE AND ASSOCIATED METHODS**

(71) Applicant: Nexperia B.V., 6534 AB Nijmegen (NL)
(72) Inventor: Hsu, Chih-Wei, Manchester (GB); Pandey, Deepak Chandra, Manchester (GB); Brown, Adam, Manchester, SK7 5BJ (GB)
(74) Representative: Pjanovic, Ilija

(57) **Abstract**

A semiconductor power device comprising an active region, the active region comprising a drift region of a first conductivity type, a body region of a second conductivity type provided over the drift region, wherein the second conductivity type is opposite to the first conductivity type, a trench in contact with the body region and the drift region, the trench comprising a gate conductive region, a source conductive region comprising first and second connected parts, the second part of the source conductive region being arranged between the gate conductive region and the first part of the source conductive region, a first insulation region arranged between the source conductive region and sidewalls of the trench, a second insulation region arranged between the source conductive region and the gate conductive region, and wherein the source conductive region is configured such that a first width of the first insulation region between each of the sidewalls of the trench and the first part of the source conductive region is larger than a second width of the first insulation region between each of the sidewalls of the trench and the second part of the source conductive region, and wherein a height of the second part is between 0.05 µm and 1/5 of a height of the first part of the source conductive region.

## Description

### Technical Field

The present disclosure relates to a power semiconductor device and a method of manufacturing a power semiconductor device, particularly but not exclusively, the present disclosure relates to a shield gate trench (SGT) metal-oxide semiconductor field-effect transistor (MOSFET).

### Background

Trench metal-oxide-semiconductor field-effect transistors (MOSFETs) are widely known and used in many applications. In a trench MOSFET, current is conducted vertically from one surface of the MOSFET to the other surface of the MOSFET.

A factor that affects a MOSFET's efficiency in switching between an ON-state, in which the current is vertically conducted, and an OFF-state, in which no current is conducted, includes a charge derived from an inherent capacitance of the MOSFET between a gate conductive region and a drain region of the MOSFET. It is desired to produce a MOSFET with a reduced charge between the gate conductive region and the drain or collector region, in order to improve the switching efficiency of the MOSFET.

### Summary

Aspects and preferred features are set out in the accompanying claims.

According to a first aspect of the present disclosure, there is provided a semiconductor power device comprising an active region, the active region comprising:
a drift region of a first conductivity type;
a body region of a second conductivity type provided over the drift region, wherein the second conductivity type is opposite to the first conductivity type;
a trench in contact with the body region and the drift region, the trench comprising:
   a gate conductive region;
   a source conductive region comprising first and second connected parts, the second part of the source conductive region being arranged between the gate conductive region and the first part of the source conductive region; and
   a first insulation region arranged between the source conductive region and sidewalls of the trench;
   a second insulation region arranged between the source conductive region and the gate conductive region; and
   wherein the source conductive region is configured such that a first width of the first insulation region between each of the sidewalls of the trench and the first part of the source conductive region is larger than a second width of the first insulation region between each of the sidewalls of the trench and the second part of the source conductive region, and wherein a height of the second part is between 0.05 µm and 1/5 of a height of the first part of the source conductive region.

By providing the source conductive region with the first and second connected parts, as described above, a charge between the gate conductive region and a drain region of the device may be reduced. This may lead to an improved switching efficiency and performance of the device.

The source conductive region may be configured such that the second part of the source conductive region extends in a direction across the sidewalls of the trench. The source conductive region may be configured such that the first part of the source conductive region extends in a direction parallel, e.g. substantially parallel, to the sidewalls of the trench.

A width of the second part of the source conductive region may be between 0.3 µm and 4.9 µm.

The height of the first part of the source conductive region may be between 0.1 µm and 10 µm.

A width of the first part of the source conductive region may be between 0.05 µm and 1 µm.

The second width of the first insulation region between each of the sidewalls of the trench and the second part of the source conductive region may be between 5% and 95% of the first width.

The first width of the first insulation region between each of the sidewalls of the trench and the first part of the source conductive region may be between 0.1 µm and 2 µm.

The source conductive region may be configured such that the second width is uniform along the height of the second part the source conductive region or varies along the height of the second part the source conductive region.

A shape of the second part of the source conductive region may comprise at least one of a quadrilateral shape and/or a rounded shape.

The semiconductor device may comprise a metal-oxide-semiconductor field-effect transistor (MOSFET) or an insulated-gate bipolar transistor (IGBT).

According to a second aspect of the present disclosure, there is provided a method of manufacturing an active region of a semiconductor power device, the method comprising:
forming a trench in a semiconductor region;
forming a first insulation region in the trench;
forming a source conductive region in the trench such that the first insulation region is arranged between the source conductive region and sidewalls of the trench, the source conductive region comprising first and second connected parts, wherein the source conductive region is formed such that a first width of the first insulation region between each of the sidewalls of the trench and the first part of the source conductive region is larger than a second width of the first insulation region between each of the sidewalls of the trench and the second part of the source conductive region, and wherein a height of the second part is between 0.05 µm and 1/5 of a height of the first part of the source conductive region;
forming a second insulation region on the second part of the source conductive region; and
forming a gate conductive region in the trench such that the second part of the source conductive region is arranged between the gate conductive region and the first part of the source conductive region.

Forming the first insulation region in the trench may comprise depositing a layer of insulating material on the semiconductor region and inner walls of the trench.

Forming the source conductive region in the trench may comprise forming the first part of the source conductive region. Forming the first part of the source conductive region may comprise:
depositing a layer of conductive material on the layer of insulating material and partially removing the layer of conductive material such that a height of the layer of conductive material is less than a height of the trench;
partially removing the layer of insulating material to expose a part of the layer of conductive material; and
removing the exposed part of the layer of conductive material to form a cavity or recess in an upper part of the trench.

Forming the source conductive region in the trench may comprise forming the second part of the source conductive region. Forming the second part of the source conductive region may comprise:
depositing a layer of conductive material in the cavity or recess formed in the upper part of the trench, the layer of conductive material connecting to the first part of the source conductive region;
partially removing the layer of conductive material to form the second part of the source conductive region.

According to a third aspect of the present disclosure, there is provided method of manufacturing a semiconductor power device comprising:
manufacturing an active region of the semiconductor power device according to the second aspect.

The device and method of manufacture of the present disclosure has one or more of the following advantages over state-of-the-art devices:
- The device may have an improved switching efficiency and performance, e.g. due to a reduction of a charge between the gate conductive region and a drain region;
- A gate bounce effect of the device may be reduced;
- The manufacturing steps may be compatible with existing MOSFET and/or IGBT manufacturing processes and/or may be performed using materials and processing equipment commonly available in MOSFET and/or IGBT fabs.

### Brief Description of the Drawings

Some embodiments of the disclosure will now be described, by way of example only and with reference to the accompanying drawings, in which:
Figure 1 shows schematically a cross-section of an active area of a semiconductor device;
Figure 2 schematically shows a cross section of an active region of a semiconductor device according to an embodiment of the disclosure;
Figure 3 schematically shows an exemplary trench shield of the device of Figure 2;
Figures 4 to 6 each schematically show an exemplary shape of a portion of the trench shield of Figure 2 or 3; and
Figure 7 illustrates steps of a method of manufacturing an active region of a semiconductor power device according to an embodiment of the disclosure.

### Detailed Description of the Preferred Embodiments

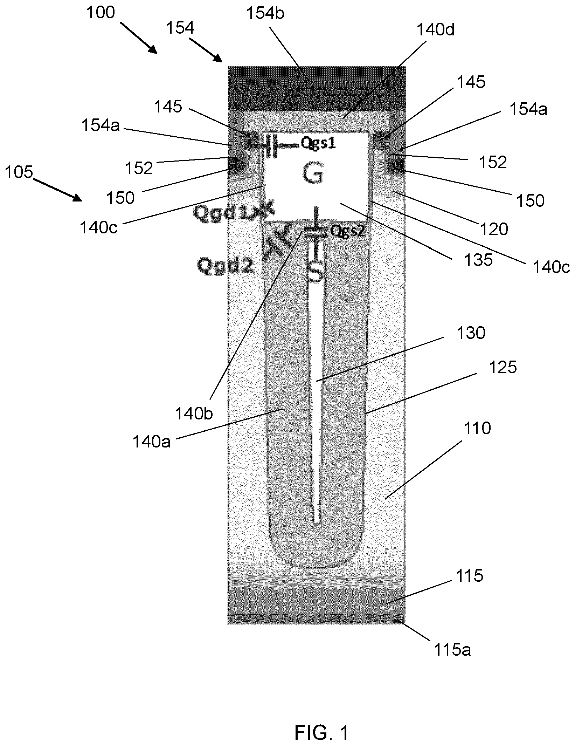

Figure 1 shows schematically a cross-section of an active area 105 of a semiconductor device 100. The active region 105 shown in Figure 1 may be considered as a unit cell, which may be repeated thousands of times in the device 100. In the examples described herein, the device is a silicon based shield gate trench MOSFET. However, it will be appreciated that the device may comprise one or more alternative semiconductor materials. For example, the device may alternatively be silicon carbide (SiC) or Gallium Nitride (GaN) based.

The active area 105 includes a drift region 110 of a first conductivity type. In the embodiment shown in Figure 1, the drift region 110 comprises an n-type doped semiconductor material. An n-dopant concentration of the drift region 110 may be between about 5 × 10¹⁴ cm⁻³ and 5 × 10¹⁷ cm⁻³. The drift region 110 may also be referred to as an n-drift region or n-type voltage sustaining region. The drift region 110 is formed on or over a semiconductor substrate. In this example, the drift region 110 comprises one or more epitaxial layers.

The substrate may comprise an n-type doped semiconductor material, such as n⁺ silicon. An n-dopant concentration of the substrate may be larger than about 5 × 10¹⁸ cm⁻³. The substrate is conductive and acts as a drain region 115. A height of the substrate may be between about 40 µm and about 100 µm. A drain contact 115a may be arranged on an underside of the substrate, e.g. a side of the substrate that is opposite to the drift region 110. The drain contact 115a may comprise a conductive material, such as a metal material.

The active area 105 includes a body region 120 of a second conductivity type. The second conductivity type is opposite to the first conductivity type. In the embodiment shown in Figure 1, the body region 120 comprises a p-type semiconductor material. The body region 120 is arranged over or above the drift region 110.

The active area 105 includes a trench 125. The trench 125 is in contact with the body region 120 and the drift region 110. For example, the body region 120 is provided on either side of an upper part of the trench 125. The drift region 110 is provided on either side of a lower part of the trench 125 and between the trench 125 and the substrate, e.g. the drain region 115.

The trench 125 includes a source conductive region. The source conductive region is referred to in the following description as a trench shield 130.

The trench 125 includes a gate conductive region 135. A height of the body region 120 may be less than a height of the gate conductive region 135. This may allow for the gate conductive region 135 being able to provide switching along a full length of the body region 120.

The trench 125 includes a first insulation region 140a. The first insulation region is arranged between sidewalls of the trench 125 and between trench shield 130. For example, the trench shield insulation region 140a may be arranged between lower portions of the sidewalls of the trench 125 and the trench shield 130 and below the trench shield 130. The first insulation region 140a may also be referred to as a trench shield insulation region 140a.

The trench 125 includes a second insulation region 140b. The second insulation region 140b is arranged between the trench shield 130 and the gate conductive region 135. The second insulating region 140b may also be referred to as an inter-poly oxide region 140b.

The trench 125 includes a third insulation region 140c. The third insulation region 140c is arranged between the sidewalls of the trench 125 and the gate conductive region 135. For example, the third insulation region 140c may be arranged between upper portions of the sidewalls of the trench 125 and the gate conductive region 135 and over or above the gate conductive region 135. The third insulation region 140c may also be referred to as a gate oxide region 140c.

The device 100, e.g. the active region 105, may comprise a fourth insulation region 140d. The fourth insulation region 140d is arranged above or over the gate conductive region 135. For example, the fourth insulation region 140d may be arranged on an upper portion of the gate oxide region 140c. The fourth insulation region may also be referred to as an interlayer dielectric layer 140d.

The trench shield 130 and the gate conductive region 135 may each be formed from a conductive material, such as a metal or a doped semiconductor material. For example, the doped semiconductor material may comprise doped polysilicon. The metal material may comprise a rare metal material, such as Tungsten. The trench shield 130 and the gate conductive region 135 may both be formed from the same doped semiconductor material. Alternatively, the trench shield 130 may be formed from the doped semiconductor material and the gate conductive region 135 may be formed from the metal material.

The device 100 includes a source contact region, which in this example is an n⁺ source contact 145 region. The n⁺ source contact region 145 is arranged above the body region 120 and on either side of the trench 125 and the gate conductive region 135. For example, the n⁺ source contact region 145 is arranged above the body region 120 and on either side of the gate oxide region 140c. During operation, a conduction channel is formed between the n⁺ source contact region 145 and the drift region 110 by application of a positive voltage to the gate conductive region 135.

The body region 120 comprises a contact region, which in this example is a p⁺ contact region 150. The p⁺ contact region 150 is formed below a contact opening or recess 152 that is formed on either side of the trench 125 and the gate conductive region 135.

The device 100 may also include a source contact 154. A first part 154a of the source contact 154 may extend into each contact opening or recess 152. The first part 154a of the source contact may be arranged to contact the n⁺ source contact 145 region and the p⁺ contact region 150.The first part 154a of the source contact 154 may comprise a conductive material, such as a metal material. The metal material may comprise tungsten, titanium or a combination thereof, such as a stack of at least one layer of tungsten and at least one layer of titanium. A second part 154b of the source contact 154 is arranged on the interlayer dielectric layer 140d. The second part 154b of the source contact 154 may comprise a conductive material, such as a metal material. The metal material may comprise aluminium or the like.

A width of the gate oxide region 140c between the gate conductive region 135 and each of the sidewalls of the trench 125 is smaller than a width of the trench shield insulation region 140a between the trench shield 130 and each of the sidewalls of the trench 125. The relatively smaller width of the gate oxide region 140c between the gate conductive region 135 and each of the sidewalls of the trench 125 allows the gate conductive region 135 to act as a gate, e.g. when a small positive voltage of about 5 V to 10 V is applied to the gate conductive region 135. The width of the gate oxide region 140c can be selected such that a breakdown of the gate oxide region 140c is prevented, e.g. when the voltage is applied to the gate conductive region 135. For example, the width of the gate oxide region 140c may be selected such that the gate oxide region 140c withstands a voltage of about 20V applied to the gate conductive region 135.

The width of the trench shield insulation region 140a between the trench shield 130 and each of the sidewalls of the trench 125 is selected such that a breakdown of the trench shield insulation region 140a is prevented, e.g. when a voltage is applied to the drain region 115 and the trench shield 130. For example, during operation, the trench shield 130 and the source contact 154 are at source potential. As the voltage that may be applied to the drain region 115 and the trench shield 130 is larger than the voltage that may be applied to the gate conductive region 135, the width of the trench shield insulation region 140a between the trench shield 130 and each of the sidewalls of the trench 125 is larger than the width of the gate oxide region 140c between the gate conductive region 135 and each of the sidewalls of the trench 125. For example, the voltage that may be applied to the drain region 115 and the trench shield 130 may be in the region of about 100 V to 200 V.

During operation, a charge Q_{gd} between the gate conductive region 135 and the drain region 115 can affect a switching efficiency of the device 100. This charge can be derived from an inherent capacitance between the gate conductive region 135 and the drain region 115 and has two components, namely Q_{gd1} and Q_{gd2}, which are indicated in Figure 1. The first component Q_{gd1} may be considered as a charge due to a capacitance across gate oxide region 140c between the gate conductive region 135 and the drift region 110. The second component Q_{gd2} may be considered as a charge due to a capacitance between the gate conductive region 135 and the drift region 110 across the inter-poly oxide region 140b and a part of the trench shield insulation region 140a. The inventors have found that Q_{gd2} plays an important role and it is desirable to reduce a value of Q_{gd2}, e.g. in order to improve the switching efficiency of the device.

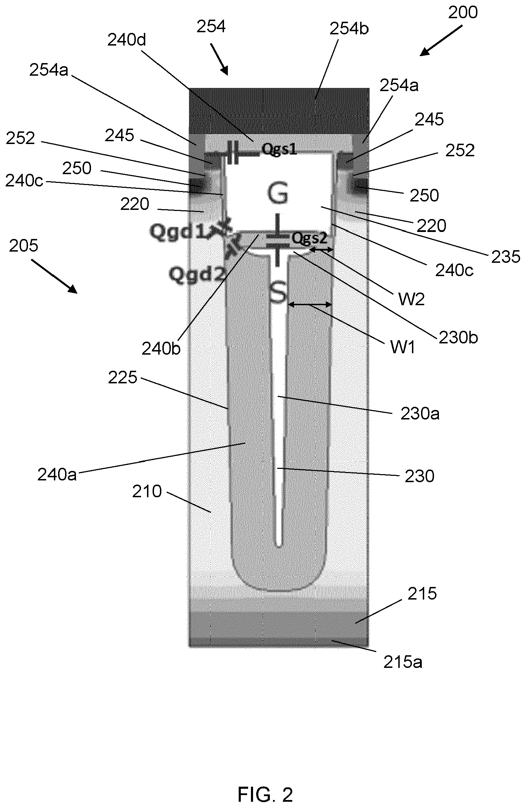

Figure 1 also shows a charge Q_{gs} due to a capacitance between the gate conductive region 135 and the trench shield 130 and due to a capacitance between the gate conductive region 135 and the n⁺ source region 145. This charge comprises a first component Q_{gs1} and a second component Q_{gs2}, both of which are indicated in Figures 1 and 2. The first component Q_{gs1} may be considered as a charge due to the capacitance between the gate conductive region 135 and the n⁺ source region 145. The second component Q_{gs2} may be considered as a charge due to the capacitance between the gate conductive region 135 and the trench shield 130 across the inter-poly oxide region 140b.

Figure 2 schematically shows a cross section of an active region 205 of a semiconductor device 200 according to an embodiment of the disclosure. The semiconductor device 200 shown in Figure 2 may comprise any of the features of the semiconductor device 100 shown in Figure 1. Only differences will be described in the following.

In the embodiment shown in Figure 2, the trench shield 230 comprises a first part 230a and a second part 230b. The first part 230a of the trench shield 230 is connected to the second part 230b of the trench shield 230. The first part 230a of the trench shield 230 may also be referred to as a pillar portion. The second part 230b of the trench shield 230 may also be referred to as a cap portion or a bar. The trench shield 230 is arranged such that the second part 230b of the trench shield 230 is arranged between the first part 230a of the trench shield 230 and the gate conductive region 235. The trench shield 230 is configured such that a first width W1 of the trench shield insulation region 240a between each of the sidewalls of the trench 225 and the first part 230a of the trench shield 230 is larger than a second width W2 of the trench shield insulation region 240a between each of the sidewalls of the trench 225 and the second part 230b of trench shield 230. For example, the first width W1 may be between about 0.1 µm and 2 µm. The second width W2 may be between about 5% and 95% of the first width W1.

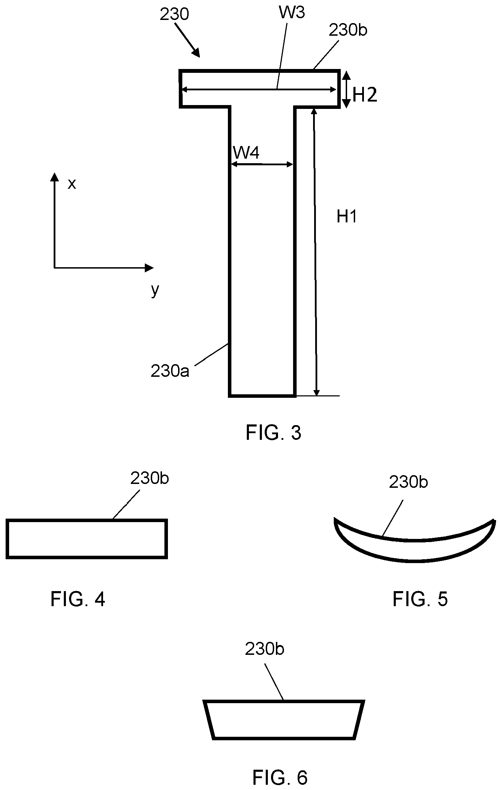

An exemplary trench shield 230 that may be part of the device 200 is schematically shown in Figure 3. A height H2 of the second part 230b is between 0.05 µm and 1/5 of a height H1 of the first part 230a of the trench shield 230. For example, the trench shield 230 may be considered as having a "T" shape. The height H2 of the second part 230b and the height H1 of the first part 230a of the trench shield 230 are indicated in Figure 3.

By providing the trench shield 230 with the second part 230b, as described above, an area of a capacitor formed between the gate conductive region 235 and the drift region 210 across the inter-poly oxide region 240b and the trench shield insulation region 240a may be reduced. As the capacitance of the capacitor is proportional to the area, the second component Q_{gd2} of the charge Q_{gd} between the gate conductive region 235 and the drain region 215 is reduced. As such, the second part 230b of the trench shield 230 may be considered as shielding the drain region 215 from the gate conductive region 235. Expressed differently, the second part 230b of the trench shield 230 may be configured to reduce or prevent the formation of electrical field lines between gate conductive region 235 and the drain region 215. This may result in a reduction of the second component Q_{gd2} of the charge Q_{gd} between the gate conductive region 235 and the drain region 215, which may result in a reduction of the total charge Q_{gd} between the gate conductive region 235 and the drain region 215. This in turn may lead to an improved Figure of Merit, which equals the product of a resistance of the device 200 and the total charge between the gate conductive region 235 and the drain region 215. The Figure of Merit is indicative of a conduction loss and switching loss of the device 200. For example, the inventors have found that the total charge Q_{gd} between the gate conductive region 235 and the drain region 215 determined for the device 200 shown in Figure 2 is reduced by about 50% relative to the total charge Q_{gd} between the gate conductive region 135 and the drain region 115 determined for the device 100 shown in Figure 1. The Figure of Merit determined for the device 200 shown in Figure 2 is reduced by about 40% relative to the Figure of Merit determined for the device 100 shown in Figure 1. The reduction of the Figure of Merit is indicative of an improved switching efficiency and reduced energy loss of the device 200 shown in Figure 2 relative to the device 100 shown in Figure 1.

In the device 200 shown in Figure 2, an area of a capacitor between the gate conductive region 235 and the trench shield 230 is increased, e.g. relative to an area of a capacitor between the gate conductive region 135 and the trench shield 130 of the device 100 shown in Figure 1. As such, the second component Q_{gs2} of the charge Q_{gs} due to the capacitance between the gate conductive region 235 and the trench shield 230 and due to the capacitance between the gate conductive region 235 and the n⁺ source region 245 of the device 200 shown in Figure 2 is increased relative to the second component Q_{gs2} of the same charge Q_{gs} of the device 100 shown in Figure 1. As such, a ratio Q_{gd2}/Q_{gs2} of the second component Q_{gd2} of the charge Q_{gd} between the gate conductive region 235 and the drain region 215 and the second component Q_{gs2} of the charge Q_{gs} due to the capacitance between the gate conductive region 235 and the trench shield 230 and due to the capacitance between the gate conductive region 235 and the n⁺ source region 245 determined for the device 200 shown in Figure 2 is decreased relative to the same ratio determined for the device 100 shown in Figure 1. Accordingly, a ratio Q_{gd}/Q_{gs} of the total charge Q_{gd} between the gate conductive region 235 and the drain region 215 and the total charge Q_{gs} due to the capacitance between the gate conductive region 235 and the trench shield 230 and due to the capacitance between the gate conductive region 235 and the n⁺ source region 245 determined for the device 200 shown in Figure 2 is reduced by about 50% relative to the same ratio determined for the device 100 shown in Figure 1. This reduction of this ratio may lead to a reduced gate bounce effect. The gate bounce effect may be due a capacitively coupled voltage at the gate conductive region of the device exceeding a threshold voltage of the device. This voltage can cause the conduction channel between the n⁺ source contact region and the drift region to be formed and may prevent the device from being turned off. The capacitively coupled voltage at the gate conductive region of the device may be due a large rate of increase of a voltage at the drain region during switching operation of the device. By reducing the second component Q_{gd2} of the charge Q_{gd} between the gate conductive region 235 and the drain region 215 and/or increasing the second component Q_{gs2} of the charge Q_{gs} due to the capacitance between the gate conductive region 235 and the trench shield 230 and due to the capacitance between the gate conductive region 235 and the n⁺ source region 245, as described above, the increase of the capacitively coupled voltage at the gate conductive region 235 with increasing voltage at the drain region 215 may be reduced or suppressed.

As such, the device 200 shown in Figure 2 can be considered as having an improved total efficiency relative to the device 100 shown in Figure 1.

By configuring the trench shield 235 such that the height H2 of the second part 230b is between 0.05 µm and 1/5 of the height H1 of the first part 230a of the trench shield 230, an effect of the second part 230b of the trench shield 230, e.g. on a breakdown voltage of the device 200, may be reduced or prevented. The breakdown voltage of the device 200 may be understood as the maximum voltage that can be applied between the drain region 215 and the n⁺ source region 245 (and the trench shield 230) without causing damage to the device 200. As such, this configuration of the trench shield 230 may be considered as allowing for the improved device performance, as described above, while simultaneously reducing or preventing any other effects on the device 200 that may be due to the second part 230b of the trench shield 230.

Referring back to Figures 2 and 3, the trench shield 230 can be configured such that the second part 230b of the trench shield 230 extends in a direction across the sidewalls of the trench 225 and the first part 230a of the trench shield 230 extends in a direction parallel, e.g. substantially parallel, to the sidewalls of the trench 225. For example, the first part 230a of the trench shield 230 may extend in a first or x-direction. The first or x-direction may also be understood as a direction from the body region 220 to the drift region 210 or substrate, e.g. drain region 215, and/or parallel to the sidewalls of the trench 225. The second part 230b of the trench shield 230 may extend in a second or y-direction. The second or y-direction is perpendicular, e.g. substantially perpendicular, to the first or x-direction. The second or y-direction can also be understood as a lateral direction of the device 200. The first or x-direction and the second or y-direction is indicated by a coordinate system in Figure 3.

A width W3 of the second part 230b of the trench shield 230 may be between about 0.3 µm and about 4.9 µm.

The height H1 of the first part 230a of the trench shield 230 may be between about 0.1 µm and about 10 µm. A width W4 of the first part 230a of the trench shield 230 may be between about 0.05 µm and about 1 µm.

Referring to Figure 2, the first width W1 of the trench shield insulation region 240a between each sidewall of the trench 225 and the first part 230a of the trench shield 230 may be generally uniform along the height H1 of the first part 230a of the trench shield 230. This may facilitate an adjustment of a doping profile of the drift region 210, e.g. to achieve one or more desired device properties, such as desired breakdown voltage and/or ON-state resistance. In examples, where the first width W1 of the trench shield insulation region 240a varies, an adjustment of the doping profile of the drift region 210 may be required to achieve the desired device properties.

The second part 230b of the trench shield 230 may be formed with different shapes. Figures 4 to 6 each schematically show an exemplary shape of the second portion 230b of the trench shield 230 shown in Figure 2 or 3.

In the example shown in Figure 4, the second part 230b of the trench shield 230 comprises a quadrilateral shape, e.g. a rectangular shape. As such, the second width of the trench shield insulation region 240a between the each of the sidewalls of the trench 230 and the second part 230b may be uniform along the height H2 of the second part 230b of the trench shield 230.

In the example shown in Figure 5, the second part 230b of the trench shield 230 comprises a rounded shape, e.g. concavo-convex shape or crescent shape. As such, the second width of the trench shield insulation region 240a between each of the sidewalls of the trench 230 and the second part 230b may vary along the height H2 of the second part 230b of the trench shield 230. It will be appreciated that in other embodiments, the second portion of the trench shield may comprise a plano-convex shape, bowl-like shape or other rounded shape.

In the example shown in Figure 6, the second part 230b of the trench shield 230 comprises a quadrilateral shape, e.g. a trapezoid shape. As such, the second width of the trench shield insulation region 240a between the sidewalls of the trench 230 and the second part 230b may vary along the height H2 of the second part 230b of the trench shield 230.

It will be appreciated that the second part 230b of the trench shield 230 is not limited to comprising one or more of the shapes shown in Figures 4 to 6. For example, in other embodiments, the second portion of the trench shield may have a different shape than those described herein.

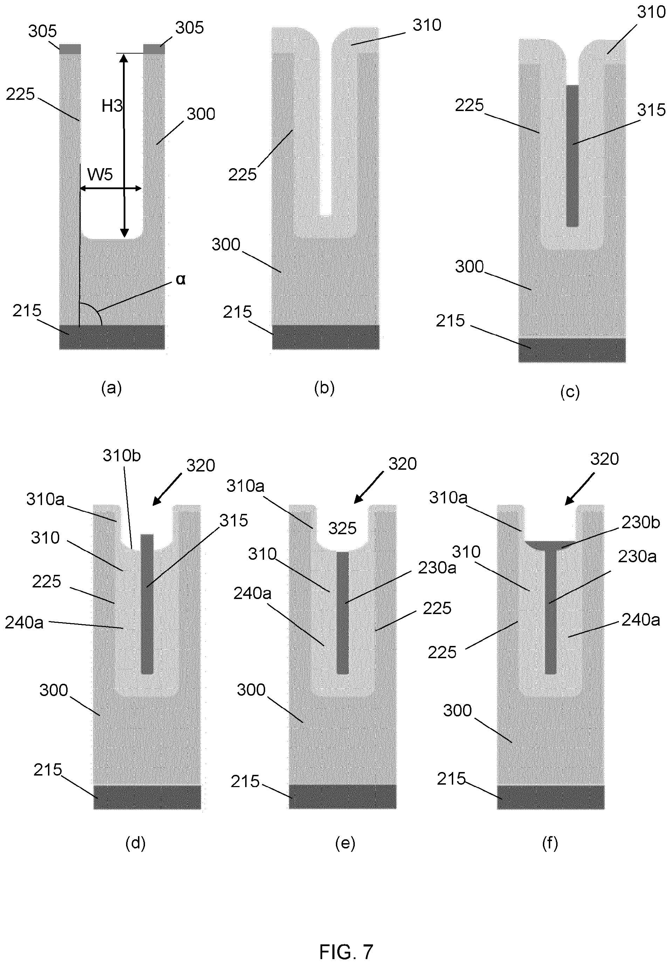

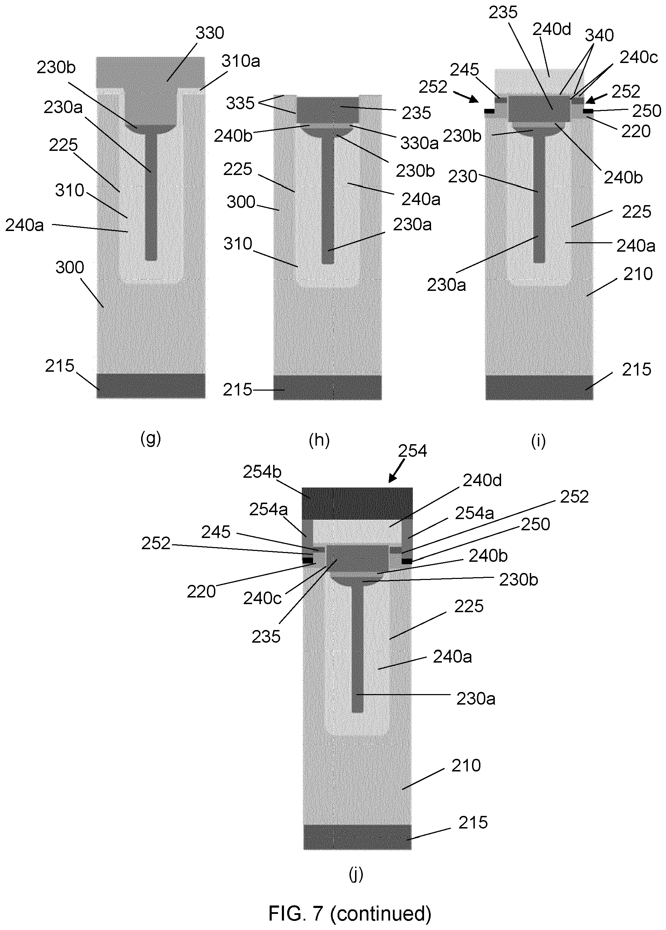

Figures 7(a) to (j) shows steps of a method of manufacturing an active region of a semiconductor power device according to an embodiment of the disclosure, such as the active region 205 of the device 200 described above. Many of the features are the same as those shown in Figure 2 and therefore carry the same reference numerals. It will be appreciated that the steps shown in Figure 7 may illustrate a subset of all the steps for manufacturing a device, and that the method may further include additional steps preceding or following the steps of Figure 7. Whilst Figure 7 shows steps in manufacturing an active area having one trench 225, it will be understood that the method may be used to manufacture more than one trench.

In step (a), the method comprises forming the trench 225 in a semiconductor region 300. The semiconductor region 300 may comprise the drift region 210. The body region 220 may be formed in the semiconductor region 300, as will be described below. The semiconductor region includes one or more epitaxial layers that have been formed on the substrate, e.g. drain region 215. The trench 225 may be formed by depositing a layer of mask material 305 on the semiconductor region 300. The mask material may comprise an oxide material, such as TEOS (tetraethyl orthosilicate), a nitride material, such as Si₃N₄, or a combination thereof, such as a stack of a layer of TEOS and a layer of the nitride material. The layer of mask material 305 may be patterned, e.g. using a material removal process, such as a dry-etch process or a wet-etch process. The patterned layer of mask material may act as a hard mask or resists layer to define the trench 225 during a material removal process, such as a dry-etch process, to form the trench 225 in the semiconductor region 300.

Subsequent to the formation of the trench 225, the layer of mask material may be removed, e.g. using a material removal process, such as a wet-etch process. The trench 225 may comprise a height H3 between about 0.1 µm and about 20 µm. The trench 225 may comprise a width W5 between about 0.3 µm and about 5 µm. The sidewalls may be formed at an angle α relative to a surface of the substrate, e.g. drain region 215. The angle may be between about 80 degrees and about 90degrees.

In steps (b) to (d), the method comprises forming the trench shield insulation region 240a in the trench 225.

In step (b), a first layer of insulating material 310 is deposited on inner walls of the trench 225 and on the semiconductor region 300, e.g. an upper surface thereof, e.g. using a deposition process. The inner wall of the trench 225 include the sidewalls and lower inner wall of the trench 225. The first layer of insulating material 310 may act as a liner of the trench 225. The insulating material may comprise an oxide material, such as Silicon Dioxide (SiO₂). In other embodiments, the insulating material may comprise an oxide material having a dielectric constant that is higher than a dielectric constant of SiO₂. For example, in such other embodiments, the oxide material may comprise Hafnium oxide (HfO₂).

In steps (c) to (f), the method comprises forming the trench shield 230. For example, in steps (c) to (e), the method comprises forming the first part 230a of the trench shield 230. The first part 230a of the trench shield 230 may be formed by depositing a layer of conductive material 315 on the first layer of insulating material 310 in the trench 225, e.g. using a deposition process. The method comprises partially removing the layer of conductive material 315 such that a height of the layer of conductive material 315 is less than the height H3 of the trench 225. The layer of conductive material 315 may be partially removed by using a material removal process, such as a dry-etch process. The conductive material may comprise a doped semiconductor material, such as polysilicon.

In step (d), the method comprises partially removing the first layer of insulating material 310 from an upper part 320 of the trench 225. The upper part of the trench 225 may also be referred to as an open end portion of the trench. A part 310a of the first layer of insulating material 310 may remain in the upper part 320 of the trench 225. The remaining part of the first layer of insulating material 310 may have a thickness that is less than a thickness of the first layer of insulating material 310 in a lower part of the trench 225. The first layer of insulating material 310 in the lower part of the trench 225 forms the trench shield insulation region 240a.

The first layer of insulating material 310 may be partially removed to expose a part of layer of conductive material 315, e.g. using a material removal process, such as a wet-etch process. The exposed part of the layer of conductive material 315 may extend or protrude from a remainder of the layer of insulating material 310 in a lower part of the trench 225. The partial removal of the first layer of insulating material 310 from the upper part 320 of the trench 225 may include shaping of a surface 310b of the remainder of the first layer of insulating material 310 in the trench 225. The shaped surface 310b of the remainder of the first layer of insulating material 310 in the trench 225 may aid in the formation and/or shaping of the second part 230b of the trench shield 230.

In step (e), the method comprises removing the exposed part of the layer of conductive material 315, e.g. using a material removal process, such as a wet etch process, to form a cavity or recess 325 in the upper part 320 of the trench 215, as shown in Figure 7(e). The layer of conductive material 315 that remains in the trench 225 forms the first part 230a of the trench shield 230.

In step (f), the method comprises forming the second part 230b of the trench shield 230. The method comprises depositing a layer of conductive material 315 into the cavity or recess 325 e.g. using a deposition process. This may facilitate the manufacture of the device 200. The layer of conductive material 315 deposited in this step connects with the same conductive material 315 that was deposited and processed in steps (c) to (e) described above to form the trench shield 230 in the trench 225. Subsequently to depositing the layer of conductive material 315 into the cavity or recess 325, the layer of conductive material 315 may be partially removed, e.g. using a material removal process, such as a dry-etch process, to form the second part 230b of the trench shield 230. For example, a remainder of the layer of conductive material 315 may form the second part 230b of the trench shield.

In steps (g) and (h), the method comprises forming the inter-poly oxide region 240b and the gate conductive region 235. For example, in step (g), the method comprises depositing a second layer of insulating material 330 on the second part 230b of the trench shield 230, e.g. using a deposition process. The insulating material may comprise an oxide material, such as Silicon Dioxide (SiO₂). The second layer of insulating material 330 may be deposited to fill the upper part 320 of the trench 225.

In step (h), the method comprises partially removing the second layer of insulating material 330 such that a part 330a of the second layer of insulating material 330 remains on the second part 230b of trench shield 230. The part 330a of the second layer of insulating material forms the inter-poly oxide region 240b. The method may also comprise removing the part 310a of the first layer of insulating material 310 from an upper portion of both the sidewalls of the trench 225 and an upper surface of the semiconductor region 300. The second layer of insulating material 330 and the part 310a of the first layer of insulating material 310 may be removed by using a material removal process, e.g. including a polishing process and a dry-etch or wet-etch process. The inter-poly oxide region 240b and the trench shield insulation region 240a may define a surface on which the gate conductive region 235 may be formed.

The method comprises forming a third layer of insulating material 335 along the upper portions of the sidewalls of the trench 225 and an upper surface of the semiconductor region 300, e.g. by oxidising the semiconductor region 300. For example, the upper portions of the sidewalls of the trench 225 may be exposed to air. The upper surface of the semiconductor region 300 may also be exposed to air. A thermal oxidation process may be used to form a part of the gate oxide region 240c on the exposed upper portions of the sidewalls of the trench 225 and the exposed upper surface of the semiconductor region 300. The thermal oxidation process may comprise a dry oxidation process, e.g. in a pure oxygen atmosphere, a wet oxidation process, such as a hydrothermal treatment, or a combination of the dry and wet oxidation processes. The third layer of insulating material 335 may define a part of the gate oxide region 240c.

The method comprises depositing a layer of conductive material on the surface defined by the trench shield insulation region 240a and the inter-poly oxide region 240b, e.g. using a deposition process, to form the gate conductive region 235. The conductive material may be the same as or different to the conductive material of the trench shield 230. The gate conductive region 235 may be planarised using a polishing process or a dry-etch process.

In step (i), the method comprises forming the body region 220. The method comprises forming a fourth layer of insulating material 340 on the gate conductive region 235 and the semiconductor region 300, e.g. to complete the gate oxide region 240c. The fourth layer of insulating material 340 may be formed on an upper surface of the gate conductive region 235 and the semiconductor region, e.g. by oxidising the semiconductor region 300 and the gate conductive region 235. The fourth layer of insulating material 340 may be considered as part of the gate oxide region 240c.

The method comprises implanting a p-type dopant (e.g. Boron) into the semiconductor region 300 below the fourth layer of insulating material 340 to form the body region 220. A p-dopant concentration of the body region 220 may be between about 10¹⁵ cm⁻³ and about 10¹⁸ cm⁻³.

The method comprises implanting an n-type dopant (e.g. Phosphor or Arsenic) above the body region 220 and below the fourth layer of insulating material 340 to form the n⁺ source contact region 245. An n-dopant concentration of the n⁺ source contact region 245 may be larger than 5 × 10¹⁸ cm⁻³.

The method comprises depositing a fifth layer of insulating material on the fourth layer of insulating material 340, e.g. using a deposition process. The fifth layer of insulating material may comprise an oxide material, such as TEOS (tetraethyl orthosilicate). The fifth layer of insulating material forms the interlayer dielectric layer 240d.

The method comprises forming contact openings or recesses 252, e.g. using a material removal process, e.g. on either side of the gate conductive region 235. For example, the contact openings or recesses 252 may be formed by etching through the n⁺ source contact region 245, extending to the body region 220. A p-type dopant (e.g. Boron or Boron difluoride) may be implanted below each contact opening or recess 252 to form the p⁺ contact region 250. A p-dopant concentration of the p⁺ contact region 250 may be larger than 5 × 10¹⁸ cm⁻³.

In step (j), the method comprises forming the source contact 254. For example, the source contact 254 may be formed by depositing a second layer of conductive material into each contact opening or recess, e.g. to form the first part 254a of the source contact 254. The method may comprise depositing a third layer of conductive material on the interlayer dielectric layer 240d, e.g. to form the second part 254b of the source contact 254.

The dry-etch process mentioned above may include a reactive ion etch process or another dry-etch process.

The deposition process mentioned above may comprise a chemical vapour deposition process or another deposition process.

The polishing process mentioned above comprises a chemical mechanical polishing process or another polishing process.

It will be appreciated that the term "width" used herein encompasses a size, dimension or extension of a part or feature in a lateral direction, e.g. the y-direction in Figure 3.

It will be appreciated that the term "height" used herein encompasses a size, dimension or extension of a part or feature in a longitudinal direction, e.g. the x-direction in Figure 3 and/or a direction perpendicular to the lateral direction.

The skilled person will understand that in the preceding description and appended claims, positional terms such as 'above', 'overlap', 'under', 'lateral, etc. are made with reference to conceptual illustrations of an apparatus, such as those showing standard cross-sectional perspectives and those shown in the appended drawings. These terms are used for ease of reference but are not intended to be of limiting nature. These terms are therefore to be understood as referring to a device when in an orientation as shown in the accompanying drawings.

It will be appreciated that all doping polarities mentioned above could be reversed, the resulting devices still being in accordance with embodiments of the present invention.

Although the above description refers to the device comprising a MOSFET, it will be appreciated that in other embodiments the device may comprise an insulated-gate bipolar transistor (IGBT). Any of the above-mentioned features may also apply to the IGBT. In such other embodiments, the terms "drain region" may be replaced with the terms "collector region" and the term "source", as used above, may be replaced with the term emitter.

In this document, dimensions are provided merely as indicative examples, and are not intended to be limiting.

It will be appreciated that Figures 1 to 7 are schematic drawings of some embodiments of the disclosure and may not be to scale.

Although specific embodiments have been described above, the claims are not limited to those embodiments. Those skilled in the art will be able to make modifications and alternatives in view of the disclosure, which are contemplated as falling within the scope of the appended claims. Each feature disclosed may be incorporated in any of the described embodiments, alone or in an appropriate combination with other features disclosed herein.

| | | | |
|---|---|---|---|
| Reference Numerals | | H1 | Height of the first part of the trench shield |
| | | | |
| 100 | Device | H2 | Height of the second part of the trench shield |
| 105 | Active region | | |
| 110 | Drift region | H3 | Height of the trench |
| 115 | Drain region | α | Angle of sidewall of trench |
| 120 | Body region | | |
| 125 | Trench | 230b | Second part of trench shield |
| 130 | Trench shield | 235 | Gate conductive region |
| 135 | Gate conductive region | 240a | Trench shield insulation region |
| 140a | Trench shield insulation region | 240b | inter-poly oxide region |
| 140b | inter-poly oxide region | 240c | gate oxide region |
| 140c | gate oxide region | 240d | interlayer dielectric layer |
| 140d | interlayer dielectric layer | 245 | n⁺ source region |
| 145 | n⁺ source region | 250 | p⁺ contact region 150 |
| 150 | p⁺ contact region 150 | 252 | Contact opening or recess |
| 152 | Contact opening or recess | 254 | Source contact |
| 154 | Source contact | 254a | First part of the source contact |
| 154a | First part of the source contact | 254b | Second part of the source contact |
| 154b | Second part of the source contact | 300 | Semiconductor region |
| 200 | Device | 305 | Layer of mask material |
| 205 | Active region | 310 | First layer of insulating material |
| 210 | Drift region | 310a | part of the first layer of insulating |
| 215 | Drain region | | material |
| 220 | Body region | 310b | Surface |
| 225 | Trench | 315 | Layer of conductive material |
| 230 | Trench shield | 320 | Upper part of the trench |
| 230a | First part of trench shield | 325 | Cavity or recess |
| W1 | first width | 330 | Second layer of insulating material |
| W2 | second width | 330a | Part of the second layer of insulating material |
| W3 | width of the second part of the trench shield | | |
| | | 335 | Third layer of insulating material |
| W4 | Width of the first part of the trench shield | 340 | Fourth layer of insulating material |
| | | | |
| W5 | Width of the trench | | |

## Claims

1. A semiconductor power device (200) comprising an active region, the active region (205) comprising:
a drift region (210) of a first conductivity type;
a body region (220) of a second conductivity type provided over the drift region (210), wherein the second conductivity type is opposite to the first conductivity type;
a trench (225) in contact with the body region (220) and the drift region (210), the trench (225) comprising:
a gate conductive region (235);
a source conductive region (230) comprising first and second connected parts (230a, 230b), the second part (230b) of the source conductive region (230) being arranged between the gate conductive region (235) and the first part (230a) of the source conductive region (230);
a first insulation region (240a) arranged between the source conductive region (230) and sidewalls of the trench (225);
a second insulation region (240b) arranged between the source conductive region (230) and the gate conductive region (235); and
wherein the source conductive region (230) is configured such that a first width (W1) of the first insulation region (240a) between each of the sidewalls of the trench (225) and the first part (230a) of the source conductive region (230) is larger than a second width (W2) of the first insulation region (240a) between each of the sidewalls of the trench (225) and the second part (230b) of the source conductive region (230), and wherein a height (H2) of the second part (230b) is between 0.05 µm and 1/5 of a height (H1) of the first part (230a) of the source conductive region (230).

2. A semiconductor power device (200) according to claim 1, wherein the source conductive region (230) is configured such that the second part (230b) of the source conductive region (230) extends in a direction across the sidewalls of the trench (225) and the first part (230a) of the source conductive region (230) extends in a direction parallel to the sidewalls of the trench (225).

3. A semiconductor power device (200) according to any preceding claim, wherein a width (W3) of the second part (230b) of the source conductive region (230) is between 0.3 µm and 4.9 µm.

4. A semiconductor power device (200) according to any preceding claim, wherein the height (H1) of the first part (230a) of the source conductive region (230) is between 0.1 µm and 10 µm.

5. A semiconductor power device (200) according to any preceding claim, wherein a width (W4) of the first part (230a) of the source conductive region (230) is between 0.05 µm and 1 µm.

6. A semiconductor power device (200) according to any preceding claim, wherein the second width (W2) is between 5% and 95% of the first width (W1).

7. A semiconductor power device (200) according to any preceding claim, wherein the first width (W1) is between 0.1 µm and 2 µm.

8. A semiconductor power device (200) according to any preceding claim, wherein the source conductive region (230) is configured such that the second width (W2) is uniform along the height (H2) of the second part (230b) the source conductive region (230) or varies along the height (H2) of the second part (230b) the source conductive region (230).

9. A semiconductor power device (200) according to any preceding claim, wherein a shape of the second part (230b) of the source conductive region (230) comprises at least one of: a quadrilateral shape and/or a rounded shape.

10. A semiconductor power device (200) according to any preceding claim, wherein the semiconductor device comprises a metal-oxide-semiconductor field-effect transistor (MOSFET) or an insulated-gate bipolar transistor (IGBT).

11. A method of manufacturing an active region (205) of a semiconductor power device (200), the method comprising:
forming a trench (225) in a semiconductor region (300);
forming a first insulation region in the trench (225);
forming a source conductive region (230) in the trench (225) such that the first insulation region (240a) is arranged between the source conductive region (230) and sidewalls of the trench (225), the source conductive region (230) comprising first and second connected parts, wherein the source conductive region (230) is formed such that a first width (W1) of the first insulation region (240a) between each of the sidewalls of the trench (225) and the first part (230a) of the source conductive region (230) is larger than a second width (W2) of the first insulation region (240a) between each of the sidewalls of the trench (225) and the second part (230b) of the source conductive region (230), and wherein a height (H2) of the second part (230b) is between 0.05 µm and 1/5 of a height (H1) of the first part (230a) of the source conductive region (230);
forming a second insulation region (240b) on the second part (230b) of the source conductive region (230); and
forming a gate conductive region (235) in the trench (225) such that the second part (230b) of the source conductive region (230) is arranged between the gate conductive region (235) and the first part (230a) of the source conductive region (230).

12. A method of manufacturing an active region (205) of a semiconductor power device (200) according to claim 11, wherein forming the first insulation region (240a) in the trench (225) comprises depositing a layer of insulating material (310) on the semiconductor region (300) and inner walls of the trench (225).

13. A method of manufacturing an active region (205) of a semiconductor power device (200) according to claim 12, wherein forming the source conductive region (230) in the trench (225) comprises forming the first part (230a) of the source conductive region (230), wherein forming the first part (230a) of the source conductive region (230) comprises:
depositing a layer of conductive material (315) on the layer of insulating material (310) and partially removing the layer of conductive material such that a height of the layer of conductive material is less than a height of the trench (225);
partially removing the layer of insulating material (310) to expose a part of the layer of conductive material; and
removing the exposed part of the layer of conductive material to form a cavity or recess (325) in an upper part (320) of the trench (225).

14. A method of manufacturing an active region (205) of a semiconductor power device (200) according to claim 13, wherein forming the source conductive region (230) in the trench (225) comprises forming the second part (230b) of the source conductive region (230), wherein forming the second part (230b) of the source conductive region (230) comprises:
depositing a layer of conductive material (315) in the cavity or recess (325) formed in the upper part (320) of the trench (225), the layer of conductive material connecting to the first part (230a) of the source conductive region (230);
partially removing the layer of conductive material to form the second part (230b) of the source conductive region (230).

15. A method of manufacturing a semiconductor power device (200) comprising:
manufacturing an active region (205) of the semiconductor power device (200) according to any one of claims 11 to 14.
